# EUROPEAN PATENT APPLICATION

(11) **EP 2 423 992 A1**
(43) Date of publication of application: **29.02.2012**
(21) Application number: 11178752.9
(22) Date of filing: 25.08.2011
(51) Int. Cl.: H01L 41/113, H02N 2/18

(54) **Micromachined piezoelectric energy harvester with polymer beam**

(30) Priority: 27.08.2010 US 377625 P
(71) Applicant: Stichting IMEC Nederland, 5656 AE Eindhoven (NL)
(72) Inventor: Van Schaijk, Rob, 5611 SG Eindhoven (NL); Goedbloed, Martijn, 52074 Aachen (DE)
(74) Representative: Sarlet, Steven Renaat Irène

(57) **Abstract**

Micromachined piezoelectric energy harvester comprising a beam (300) provided for resonating with an external vibration, at least one piezoelectric transducer (20, 60) provided on the beam and adapted for being mechanically stressed by the resonating beam to generate electric energy, and at least one mass (100, 200) provided on the beam. The beam (300) is made of a polymer.

## Description

### Technical field

The present invention relates to a micromachined piezoelectric energy harvester comprising a resonating beam and to a method for fabricating such a micromachined energy harvester.

### Background art

Future wireless sensor networks will comprise sensor nodes which occupy a volume of typically a few cm³. The scaling down of batteries for powering these sensor nodes faces technological restrictions as well as a loss in storage density. For this reason a worldwide effort is ongoing to replace batteries with more efficient, miniaturized power sources. Energy harvesters based on the recuperation of waste ambient energy are a possible alternative to batteries. Several harvesting concepts have been proposed, based on the conversion of thermal energy, pressure energy or kinetic energy.

Kinetic energy harvesters or vibration energy harvesters convert energy in the form of mechanical movement (e.g. in the form of vibrations or random displacements) into electrical energy. For the conversion of kinetic energy into electrical energy different conversion mechanisms may be employed. For example, piezoelectric conversion can be employed, using piezoelectric materials that generate a charge when mechanically stressed.

Piezoelectric energy harvesters are often resonant systems. Their resonance frequency is given by 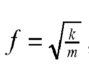 , wherein k is the stiffness and m the mass of a resonator part. For many applications a low resonance frequency (e.g. lower than 100 Hz) is needed. This can be obtained by increasing the mass or by lowering the stiffness of the resonating beam.

A possible route towards cheap harvesting devices is using microsystems manufacturing technology. Micromachined devices can be made on a wafer basis in a batch mode, greatly reducing the cost. However, for micromachined resonators, e.g. micromachined piezoelectric energy harvesters, it is difficult to increase the mass and therefore lowering the stiffness is the most viable option when there is a need for lowering the resonance frequency.

Using a standard single clamped beam harvester with a silicon beam the lower limit of resonance is about 150Hz for a device size up to 1cm². This lower limit is related to the high stiffness of a silicon beam and to the small device size.

Besides the requirement of a low resonance frequency, the power output of the micromachined energy harvester is preferably as high as possible. Therefore, the stiffness of the beam should be sufficiently high to generate enough strain in the piezoelectric transducer.

### Disclosure of the invention

It is an aim of the invention to provide micromachined piezoelectric energy harvesters having a lower resonance frequency without increasing the device size.

It is another aim of the invention to provide a method for manufacturing such a micromachined piezoelectric energy harvester.

These aims are achieved with the subject-matter of the independent claims.

The invention provides a micromachined piezoelectric energy harvester comprising a resonating beam, for resonating with an external vibration or kinetic energy source, at least one piezoelectric transducer on the beam, which is mechanically stressed by the resonating beam and thereby generates electric energy, and at least one mass attached to the beam, which is provided to ensure that when the beam resonates enough strain is generated in the piezoelectric transducer. According to the invention the beam is made of a polymer.

It is an advantage of a micromachined piezoelectric energy harvester according to the present invention that it comprises a resonator beam having a lower stiffness than prior art micromachined devices of comparable dimensions (e.g. smaller than 1 cm²) having e.g. a silicon beam, resulting in a lower resonance frequency.

It is an advantage of a micromachined piezoelectric energy harvester of the present invention that its reliability can be better as compared to piezoelectric energy harvesters having for example a silicon beam. It is an advantage of using a polymer beam instead of a silicon beam that a polymer is less brittle than silicon and that it may withstand larger shocks.

The clamped beam of a micromachined piezoelectric energy harvester of the present invention can be a single side clamped beam (cantilever) or a double side clamped beam.

In embodiments of the invention, a polymer having a Young's modulus lower than 20 GPa is used. For example, the resonance frequency of a micromachined piezoelectric energy harvester of the present invention can be in the range between 50 Hz and 200 Hz. The power output can be in the range between 10 microWatt/cm² and 100 microWatt/cm².

In preferred embodiments of the invention, the micromachined piezoelectric energy harvester comprises a first mass attached to a first surface of the beam and a second mass attached to a second surface of the beam opposite to the first surface. The first mass and/or the second mass can for example be silicon masses. However, the present invention is not limited thereto and other materials than silicon can be used for forming at least part of a mass.

In embodiments comprising two masses, i.e. a first mass and a second mass, the total mass can be larger than in prior art mircromachined devices, resulting in a lower resonance frequency and a larger power output.

It is an advantage of a micromachined piezoelectric energy harvester of the present invention that it can have a symmetric structure, resulting in a compensation of stresses.

The present invention further provides a method for fabricating a micromachined piezoelectric energy harvester. The method of the present invention comprises:
- fabricating a first device part comprising a first polymer sub-beam, a first piezoelectric transducer embedded in the first polymer sub-beam and a first mass attached to a first surface of the first polymer sub-beam;
- fabricating a second device part comprising a second polymer sub-beam, a second piezoelectric transducer embedded in the second polymer sub-beam and a second mass attached to a first surface of the second polymer sub-beam;
- bonding the second device part to the first device part. wherein a second surface of the first polymer sub-beam opposite to its first surface faces a second surface of the second polymer sub-beam opposite to its first surface, thereby bonding the first polymer sub-beam and the second polymer sub-beam to form a single polymer beam; and
- performing an etch step for releasing the single polymer beam.

The method may further comprise providing a first cover plate at a first side of the polymer beam and providing a second cover plate at a second side of the polymer beam, thereby providing a package for the resonator wherein e.g. a non-clamped end of the polymer beam and the first mass and the second mass can move in response to e.g. external vibrations.

It is an advantage of a method according to the present invention that it is a relatively simple method and that it is based on silicon MEMS processing. This allows high volume manufacturing at low cost.

It is an advantage of a method according to the present invention that it can provide stress compensation because of the symmetry of the structure. In case of a non-symmetric structure, i.e. a structure comprising a single polymer beam with a single piezoelectric transducer and a single mass, a large amount of stress could be present in the polymer beam due to the presence of a piezoelectric transducer on top of or embedded in the polymer beam, and after release of the polymer beam the beam e.g. cantilever could bend as a result of this stress. The stress can be compensated for by adding stress compensating layers, but this is a difficult process. In embodiments of the present invention two device parts each comprising a polymer sub-beam with an integrated piezoelectric transducer are bonded before release of the polymer beam. In this way a symmetric structure is obtained and the stress is compensated by the device configuration irrespective of device sizes and designs.

### Brief description of the drawings

The invention will be further elucidated by means of the following description and the appended drawings.
Figure 1 shows a schematic cross section of a micromachined piezoelectric energy harvester according to the present disclosure.
Figure 2 illustrates a process flow for fabricating a first device part according to a method of the present disclosure.
Figure 3 illustrates a process flow for fabricating a second device part according to a method of the present disclosure.

Any reference signs in the claims shall not be construed as limiting the scope of the present invention.

In the different drawings, the same reference signs refer to the same or analogous elements.

### Modes for carrying out the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein can operate in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

A micromachined piezoelectric energy harvester according to embodiments of the present invention comprises a resonator comprising a single side or double side clamped beam having a low Young's modulus, at least one piezoelectric transducer integrated with or embedded in the clamped beam, and at least one mass attached to a surface of the beam. The micromachined piezoelectric harvester is preferably silicon based and the beam is preferably a polymer beam. As compared to prior art micromachined resonators, wherein a silicon beam is used, this results in a lower stiffness for the same beam dimensions because of the lower Young's modulus of a polymer as compared to silicon. The lower stiffness results in a lower resonance frequency. In a micromachined piezoelectric energy harvester according to embodiments of the present invention, at least one piezoelectric transducer is integrated with the polymer beam and at least one mass, is attached to the polymer beam. In preferred embodiments two piezoelectric transducers, i.e. a first piezoelectric transducer and a second piezoelectric transducer are symmetrically integrated with the polymer beam, and two masses, i.e. a first mass and a second mass are attached to opposing surfaces of the beam. By providing two masses, the total mass can be larger than in prior art devices having a single mass; this can result in a lower resonance frequency and a higher power output.

In a fabrication process of a device of the present invention, before release of the polymer beam, two device parts each comprising a polymer sub-beam with an integrated piezoelectric transducer are bonded on top of each other such that the bonded polymer sub-beams form a single polymer beam. In this way the stress can be compensated for all device sizes and designs in the configuration of the device itself, and bending of the beam after release can be avoided. No new stress optimization is needed every time the layer stack or thickness in the process flow is changed.

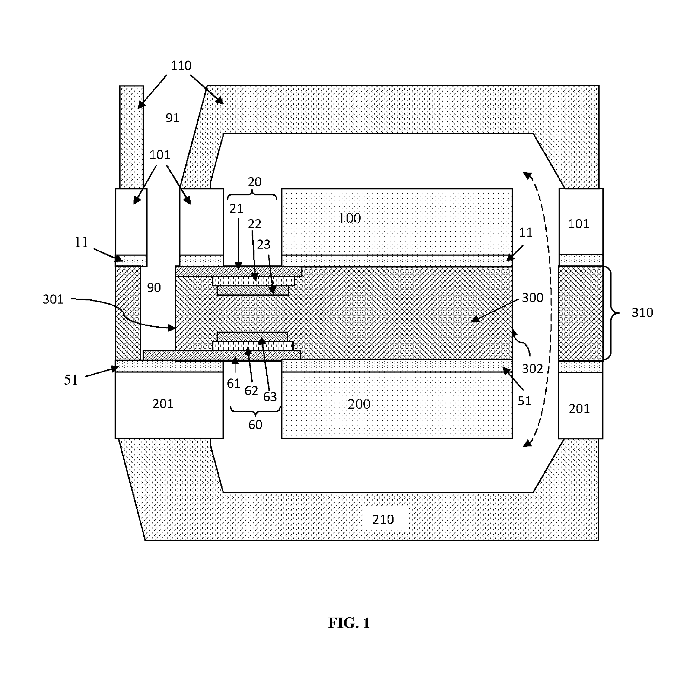

A schematic cross section of a micromachined piezoelectric energy harvester according to an exemplary embodiment of the present invention is shown in Figure 1. The harvester comprises a single side clamped polymer beam 300, a first silicon mass 100 attached to a first surface of the beam 300 and a second silicon mass 200 attached to a second surface of the beam 300 opposite to the first surface. It further comprises a first piezoelectric transducer 20 embedded in the beam 300 and a second piezoelectric transducer 60 embedded in the beam 300. In the example shown, the first piezoelectric transducer 20 is a piezoelectric capacitor structure comprising a stack of a first electrode 21, a piezoelectric layer 22 and a second electrode 23, the stack being embedded in the beam 300 at the first surface of the beam. In the example shown, the second piezoelectric transducer 60 is a piezoelectric capacitor structure comprising a stack of a first electrode 61, a piezoelectric layer 62 and a second electrode 63, the stack being embedded in the beam 300 at the second surface of the beam. However, the present invention is not limited thereto and other configurations are possible. For example, a configuration with a single piezoelectric capacitor structure can be used, leading to easier electrical contacting. For example, instead of a piezoelectric capacitor stack, piezoelectric transducers comprising two interdigitated electrodes at one side of a piezoelectric layer can be used. For example, a plurality of series connected transducers can be provided, leading to a higher output voltage of the harvester. These examples are not limiting, and still other suitable configurations can be used.

The polymer beam 300 is clamped at a first end 301. Thereto, the beam 300 is physically attached to a frame or a support structure at the first end 301, the support structure comprising a first support part 101 and a second support part 201. The beam 300 and is free to move at a second end 302 opposite to the first end, in a direction indicated by the dashed arrow. The first support part 101 is attached to the second support part 102 by a polymer layer 310. In advantageous embodiments of the present invention, the polymer layer 310, bonding the first support part 101 and the second support part 102, is the same layer as the polymer layer from which the single side clamped polymer beam 300 is fabricated. However, the present invention is not limited thereto and the material used for forming the bonding polymer layer 310 can be different from the material used for forming the polymer beam 300.

In preferred embodiments the first mass 100 and the second mass 200 are provided near the second end 302 of the beam 300, the first piezoelectric transducer 20 is provided along the polymer beam 300 at a location in between the first mass 100 and the first end 301, and the second piezoelectric transducer 60 is provided along the polymer beam 300 at a location in between the second mass 200 and the first end 301. In the example shown in Figure 1, a contact hole 90 is provided through the first support part 101 and through the polymer layer 310 towards the first electrode 61 of the second piezoelectric transducer 60, such that an electrical contact can be made to both the first transducer 20 and the second transducer 60 from a same side of the harvester. Alternatively, electrical contacts to the second piezoelectric transducer 60 can also be provided at a side of the energy harvester opposite to the side where electrical contacts to the first piezoelectric transducer 20 are provided. However, in preferred embodiments the electrical contacts to both transducers are provided at a single side of the harvester.

The piezoelectric energy harvester shown in Figure 1 further comprises a dielectric layer 11 between the first mass 100 and first support part 101 at one hand and the polymer beam 300 with integrated piezoelectric transducer 20 at the other hand. It further comprises a dielectric layer 51 between the second mass 200 and the second support part 201 at one hand and the polymer beam 300 with integrated piezoelectric transducer 60 at the other hand. These dielectric layers 11, 51 provide electrical isolation between the silicon part of the device and the piezoelectric transducers 20, 60. In addition, these dielectric layers 11, 51 have a function in a fabrication process of a piezoelectric harvester, wherein they are used as an etch stop layer (as further described).

The piezoelectric energy harvester of the present invention further comprises a first cover plate 110 and a second cover plate 210, forming a package for the resonator (comprising the beam 300, first mass 100 and second mass 200) of the harvester. The first cover plate 110 is attached to the first support part 101 and the second cover plate 210 is attached to the second support part 201. In between the first cover plate 110 and the second cover plate 210 sufficient space is left to enable up-and-down movement (indicated by the dashed arrows) of the resonator. As shown in Figure 1, an opening 91 is provided in the first cover plate 110 to allow access to the piezoelectric transducers 20, 60.

In operation, when the support structure 101, 102 moves, for example due to external vibrations, the masses 100 and 200 move up and down (as indicated by the dashed arrows in Figure 1), resulting in bending of the beam 300 at the location of the first piezoelectric transducer 20 and the second piezoelectric transducer 60. This bending of the beam 300 creates an electrical potential difference between the first electrode 21 and second electrode 23 of the first piezoelectric transducer 20 and between the first electrode 61 and second electrode 63 of the second piezoelectric transducer 60. These potential differences can then be converted to electrical energy by proper circuitry (not illustrated).

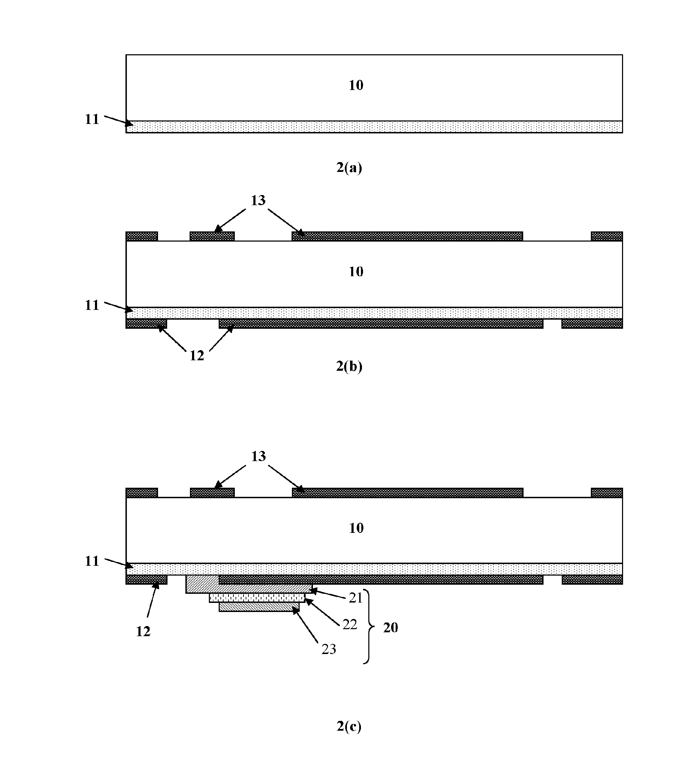

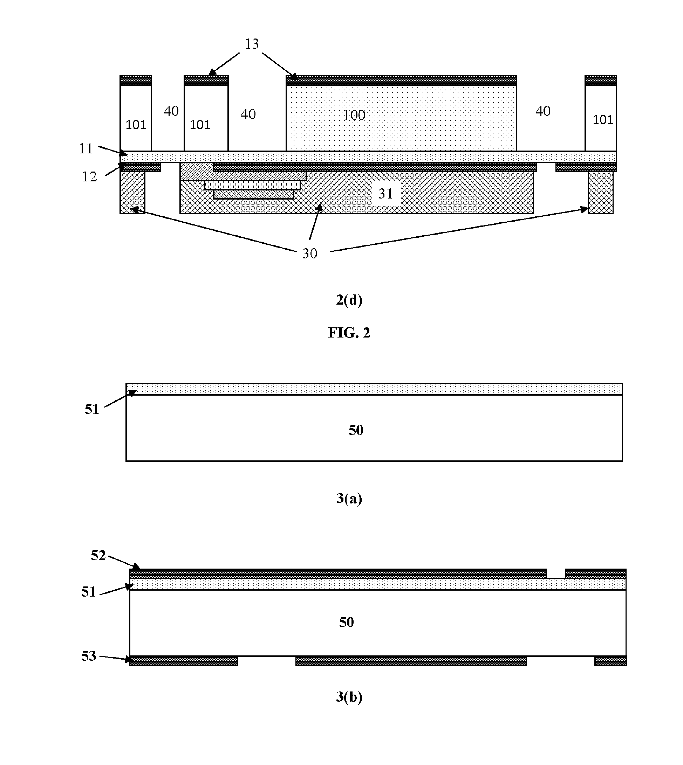

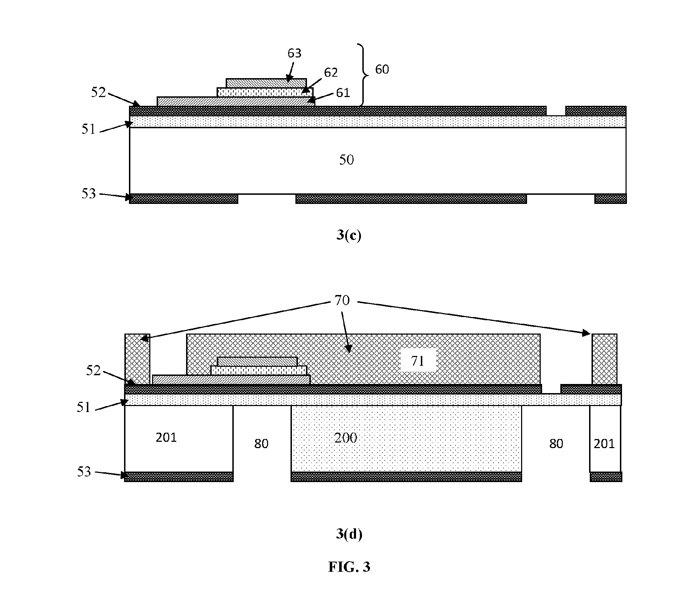

A process flow that may be used for fabricating a micromachined piezoelectric energy harvester according to the present invention (e.g. as shown in Figure 1) is further described and schematically illustrated in Figure 2 and Figure 3. However, the present invention is not limited thereto and other suitable fabrication processes may be used.

In the exemplary manufacturing process illustrated in Figure 2 and Figure 3, two silicon wafers are used, further referred to as the first device wafer and the second device wafer.

Figure 2 schematically illustrates the process steps performed on the first device wafer 10. At a first side (further referred to as the front side or device side) of the first device wafer 10 a dielectric layer 11 is provided, for example a 2 micrometer thick oxide layer. This is illustrated in Figure 2(a). Other materials than an oxide can be used for forming the dielectric layer 11, such as for example SiN, SiC, Al₂O₃ or any other suitable material known to a person skilled in the art. The thickness of the dielectric layer 11 can for example be in the range between 100 nm and 10 micrometer. It has an etch stop function in the further fabrication process as well as an electrical isolation function in the final device. Next a first hard mask layer 12 such as for example a silicon nitride layer is provided on the dielectric layer 11 and a second hard mask layer 13 such as for example a silicon nitride layer is provided on the back side (the side opposite to the front side) of the first device wafer 10. The first hard mask layer 12 and the second hard mask layer 13 are then patterned. At the back side of the first device wafer 10 the second hard mask layer 13 is removed at locations where trenches need to be etched in a later stage of the process for forming a first mass and for forming a contact hole. At the front side of the first device wafer 10 the first hard mask layer 12 it is removed at locations where a contact hole to a piezoelectric transducer needs to be provided and at locations where a polymer beam release etching need to be done in a later stage of the process. The resulting structure is shown in Figure 2(b). Next, as illustrated in Figure 2(c), a first piezoelectric transducer 20 is provided on the first hard mask layer 12. In the example shown, the first piezoelectric transducer 20 is a capacitor structure comprising a stack of layers, the stack comprising a first electrode 21, a piezoelectric layer 22 and a second electrode 23. Preferably the first piezoelectric transducer 20 spans the opening defined in the second hard mask layer 13 at an opposite side of the first device wafer 10, opposite to the capacitor structure. This enables later contacting of the first piezoelectric transducer 20. After providing the first piezoelectric transducer 20, a first polymer layer 30 such as for example a layer comprising Su-8, BCB or parylene is provided at the device side. In embodiments of the present invention a single polymer or a combination of different polymers, e.g. a stack of different polymers layers, can be used for forming the first polymer layer 30. The first polymer layer 30 is patterned, thereby defining a first polymer sub-beam 31. More in particular, the polymer layer is removed at a location where a contact hole needs to be formed and at locations where a polymer beam release etching needs to be done in a later stage of the process (Figure 2(d)). Finally the first device wafer 10 is etched from the back side, using the second hard mask layer 13 as a mask and using the dielectric layer 11 as an etch stop layer. Etching of the first device wafer can for example be done by Deep Reactive Ion Etching. However, other suitable etching methods known to a person skilled in the art may be used. This etching step results in trenches 40 completely through the first device wafer 10 (i.e. extending from the rear side to the front side of the first device wafer 10). As a result of the etching step a first mass 100 and a first support part 101 are formed from the first device wafer 10 (Figure 2(d)).

Figure 3 schematically illustrates the process steps performed on the second device wafer 50. On a first surface (further referred to as the front side or device side) of the second device wafer 50 a dielectric layer 51 is provided, for example a 2 micrometer thick oxide layer. This is illustrated in Figure 3(a). Other materials than an oxide can be used for forming the dielectric layer 51, such as for example SiN, SiC, Al₂O₃ or any other suitable material known to a person skilled in the art. The thickness of the dielectric layer 51 can for example be in the range between 100 nm and 10 micrometer. It has an etch stop function in the further fabrication process as well as an electrical isolation function in the final device. Next a first hard mask layer 52 such as for example a silicon nitride layer is provided on the dielectric layer 51 and a second hard mask layer 53 such as for example a silicon nitride layer is provided on the back side (the side opposite to the front side) of the second device wafer 50. The first hard mask layer 52 and the second hard mask layer 53 are then patterned. At the back side of the second device wafer 50 the second hard mask layer 53 is removed at locations where trenches need to be etched in a later stage of the process for forming a second mass. At the front side of the second device wafer 50 the first hard mask layer 52 is removed at locations where a polymer beam release etching needs to be done in a later stage of the process. The resulting structure is shown in Figure 3(b). Next, as illustrated in Figure 3(c), a second piezoelectric transducer 60 is provided on the first hard mask layer 52. In the example shown, the second piezoelectric transducer 60 is a capacitor structure comprising a stack of layers, the stack comprising a first electrode 61, a piezoelectric layer 62 and a second electrode 63. After providing the second piezoelectric transducer 60, a second polymer layer 70 such as for example a layer comprising Su-8, BCB or parylene is provided at the device side. In embodiments of the present invention a single polymer or a combination of different polymers, e.g. a stack of different polymer layers, can be used for forming the second polymer layer 70. The second polymer layer 70 is patterned, thereby defining the second polymer sub-beam 71. More in particular, the second polymer layer 70 is removed at a location where a contact hole needs to be formed and at locations where a polymer beam release etching needs to be done in a later stage of the process (Figure 3(d)). Finally the second device wafer 50 is etched from the back side, using the second hard mask layer 53 as a mask and using the dielectric layer 51 as an etch stop layer. Etching of the second device wafer can for example be done by Deep Reactive Ion Etching. However, other suitable etching methods known to a person skilled in the art may be used. This etching step results in trenches 80 completely through the second device wafer 50 (i.e. extending from the rear side to the front side of the device bottom wafer 50). As a result of the etching step a second mass 200 and a second support part 201 are formed from the second device wafer 50 (Figure 3(d)). In the embodiment illustrated there is no need for providing a contact hole through the second device wafer, because a contact to the second piezoelectric transducer 60 is provided through the first device wafer.

In a next step the first device part (as shown in Figure 2(d)) and the second device part (as shown in Figure 3(d)) are bonded to each other with their device side (front side) facing each other, i.e. with the first polymer layer 30 and the second polymer layer 70 facing each other. After bonding, the first polymer layer 30 and the second polymer layer 70 form a single polymer layer 310 (Figure 1). After bonding, the first polymer sub-beam 31 and the second polymer sub-beam 71 form a single polymer beam 300 (as shown in Figure 1). After bonding, the first support part 101 and the second support part 201 are attached to each other by the polymer layer 310.

Next an oxide etching step is performed at both sides of the bonded structure, thereby removing the exposed parts of dielectric layer 11 and of dielectric layer 51. This etching step results in a release of (the second end 302 of) the polymer beam 300. The etching step can be performed by wet etching (e.g. HF) if the polymer layer 310 provides sufficient protection or it can be performed by dry etching.

In a next step a first cover plate 110 is attached to the first support part 101 and a second cover plate 210 is attached to the second support part 201, thereby forming a package for the resonator. The first cover plate and the second cover plate each have a cavity such that sufficient space is left to allow up-and-down movement of the resonator. The first cover plate and the second cover plate can for example be fabricated based on a glass wafer or based on a silicon wafer, or any other suitable material known to a person skilled in the art. Forming a cavity can comprise: providing a hardmask, such as for example a metal hardmask; patterning the hardmask; and etching the cavity, for example in HF or any other suitable etchant, thereby using the hardmask as an etching mask. As illustrated in Figure 1, in the first cover plate 110 an opening or contact hole (through-hole) 91 is provided to allow access to the piezoelectric transducers 20, 60. Such a contact hole can for example be formed by powder blasting.

Attaching the first cover plate 110 to the first support part 101 and attaching the second cover plate 210 to the second support part 201 can for example be done by wafer bonding. A layer of bonding material, for example a layer of polymer material (not illustrated in Figure 1), can be provided at the non-etched portions of the first cover plate 110 and the second cover plate 210 to enable this wafer bonding.

## Claims

1. Micromachined piezoelectric energy harvester comprising a beam (300) provided for resonating with an external vibration, at least one piezoelectric transducer (20, 60) provided on the beam and adapted for being mechanically stressed by the resonating beam to generate electric energy, and at least one mass (100, 200) provided on the beam, **characterized in that** the beam (300) is made of a polymer.

2. Micromachined piezoelectric energy harvester according to claim 1, **characterized in that** the polymer has a Young's modulus lower than 20 GPa.

3. Micromachined piezoelectric energy harvester according to claim 1 or 2, **characterised in that** the beam has a resonance frequency in the range between 50 Hz and 200 Hz.

4. Micromachined piezoelectric energy harvester according to any one of the previous claims, **characterised in that** the at least one mass comprises a first mass (100) attached to a first surface of the beam and a second mass (200) attached to a second surface of the beam opposite to the first surface.

5. Micromachined piezoelectric energy harvester according to any one of the previous claims, **characterised in that** each mass (100, 200) is made of silicon.

6. Micromachined piezoelectric energy harvester according to any one of the previous claims, **characterised in that** a dielectric (11, 51) is provided between the beam and each mass.

7. Micromachined piezoelectric energy harvester according to any one of the previous claims, **characterised in that** it has a symmetric structure.

8. Micromachined piezoelectric energy harvester according to any one of the previous claims, **characterised in that** the at least one piezoelectric transducer comprises a first piezoelectric transducer (20) and a second piezoelectric transducer (60) symmetrically integrated with the beam.

9. Micromachined piezoelectric energy harvester according to claim 8, **characterised in that** the first piezoelectric transducer (20) is a piezoelectric capacitor structure comprising a stack of a first electrode (21), a piezoelectric layer (22) and a second electrode (23), the stack being embedded in the beam (300) at a first surface of the beam, and **in that** the second piezoelectric transducer (60) is a piezoelectric capacitor structure comprising a stack of a first electrode (61), a piezoelectric layer (62) and a second electrode (63), the stack being embedded in the beam (300) at a second surface of the beam.

10. Micromachined piezoelectric energy harvester according to any one of the claims 1-7, **characterised in that** each piezoelectric transducer comprises two interdigitated electrodes at one side of a piezoelectric layer.

11. Micromachined piezoelectric energy harvester according to any one of the previous claims, **characterised in that** a plurality of series connected piezoelectric transducers are provided.

12. Micromachined piezoelectric energy harvester according to any one of the previous claims, **characterised in that** it is smaller than 1 cm².

13. Method for fabricating a micromachined piezoelectric energy harvester, comprising the steps of:
- fabricating a first device part comprising a first polymer sub-beam, a first piezoelectric transducer embedded in the first polymer sub-beam and a first mass attached to a first surface of the first polymer sub-beam;
- fabricating a second device part comprising a second polymer sub-beam, a second piezoelectric transducer embedded in the second polymer sub-beam and a second mass attached to a first surface of the second polymer sub-beam;
- bonding the second device part to the first device part, wherein a second surface of the first polymer sub-beam opposite to its first surface faces a second surface of the second polymer sub-beam opposite to its first surface, thereby bonding the first polymer sub-beam and the second polymer sub-beam to form a single polymer beam; and
- performing an etch step for releasing the single polymer beam.

14. Method according to claim 13, **characterized in that** the method further comprises providing a first cover plate at a first side of the polymer beam and providing a second cover plate at a second side of the polymer beam, thereby providing a package for the resonator wherein a non-clamped end of the polymer beam and the attached first and second masses is moveable in response to external vibrations.

15. Method according to claim 14, **characterized in that** the first and second cover plates are attached by wafer bonding.

16. Method according to any one of the claim 14 or 15, **characterized in that** the method further comprises providing a contact hole (91) through the first cover plate to provide access to the piezoelectric transducers (20, 60).
